# EUROPEAN PATENT APPLICATION

(11) **EP 1 956 106 A2**
(43) Date of publication of application: **13.08.2008**
(21) Application number: 07123880.2
(22) Date of filing: 20.12.2007
(51) Int. Cl.: C22C 27/00, C23C 14/34, G11B 5/64

(54) **Re-based alloys usable as deposition targets for forming interlayers in granular perpendicular magnetic recording media & media utilizing said alloys**

(30) Priority: 08.01.2007 US 879418 P; 23.10.2007 US 877587
(71) Applicant: Heraeus, Inc., Chandler AZ 85226 (US)
(72) Inventor: Das, Anirban, Chandler, AZ 85225 (US); Racine, Michael Gene, Phoenix, AZ 85044 (US); Imakawa, Makoto, Phoenix, AZ 85048 (US); Kennedy, Steven Roger, Chandler, AZ 85226 (US); Arora, Rikhit, Chandler, AZ 85226 (US)
(74) Representative: Hill, Justin John

(57) **Abstract**

A Re-based alloy material comprises > 50 at. % Re and at least one alloying material selected from grain size refinement elements X which have an atomic radius larger or smaller than that of Re and a solid solubility < ~6 at. % in *hcp* Re at room or higher temperatures, and lattice matching elements Y which have an atomic radius larger or smaller than that of Re and form a solid solution in *hcp* Re at room or higher temperatures. The alloy material may further comprise at least one material selected from the group consisting of oxides, nitrides, and carbides. Targets comprising the Re-based alloy material are useful in sputter deposition of improved interlayers for obtaining optimally structured granular perpendicular magnetic recording layers.

## Description

### FIELD OF THE DISCLOSURE

The present disclosure relates to Re-based alloys, deposition targets comprising same, and to thin film magnetic recording media comprising Re-based alloy interlayers. The invention has particular utility in the manufacture of high performance, high areal recording density, granular perpendicular media utilizing Re-based alloy sputtering targets for forming improved interlayers underlying granular perpendicular magnetic recording layers.

### BACKGROUND OF THE DISCLOSURE

Magnetic media are widely used in various applications, particularly in the computer industry for data/information storage and retrieval applications, typically in disk form, and efforts are continually made with the aim of increasing the areal recording density, i.e., bit density of the magnetic media. Conventional thin film thin-film type magnetic media, wherein a fine-grained polycrystalline magnetic alloy layer serves as the active recording layer, are generally classified as "longitudinal" or "perpendicular", depending upon the orientation of the magnetic domains of the grains of magnetic material.

The perpendicular recording media have been found to be superior to the more conventional longitudinal media in achieving very high bit densities. In perpendicular magnetic recording media, residual magnetization is formed in a direction perpendicular to the surface of the magnetic medium, typically a layer of a magnetic material on a suitable substrate. Very high linear recording densities are obtainable by utilizing a "single-pole" magnetic transducer or "head" with such perpendicular magnetic media.

Efficient, high bit density recording utilizing a perpendicular magnetic medium requires interposition of a relatively thick (as compared with the magnetic recording layer), magnetically "soft" underlayer ("SUL"), i.e., a magnetic layer having a relatively low coercivity below about 100 Oe, such as of a NiFe alloy (Permalloy), between the non-magnetic substrate, e.g., of glass, aluminum (Al) or an Al-based alloy, and the magnetically "bard" recording layer having relatively high coercivity, typically about 3 - 8 kOe, e.g., of a cobalt-based alloy (e.g., a Co-Cr alloy such as CoCrPtB) having perpendicular anisotropy. The magnetically soft underlayer serves to guide magnetic flux emanating from the head through the hard, perpendicular magnetic recording layer.

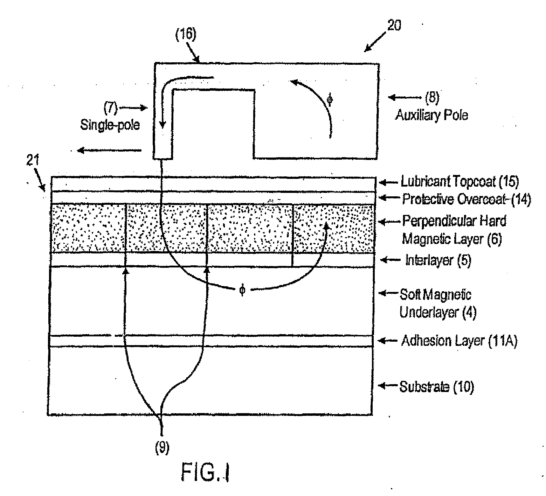

A typical conventional perpendicular recording system **20** utilizing a vertically oriented magnetic medium **21** with a relatively thick soft magnetic underlayer, a relatively thin hard magnetic recording layer, and a single-pole head, is illustrated in FIG. 1, wherein reference numerals **10**, **11A**, **4**, **5**, and **6** respectively indicate a non-magnetic substrate, an adhesion layer (optional), a soft magnetic underlayer, at least one non-magnetic interlayer, and at least one perpendicular hard magnetic recording layer. Reference numerals **7** and **8**, respectively, indicate the single and auxiliary poles of a single-pole magnetic transducer head **16**.

Briefly stated, the relatively thin interlayer **5** (also referred to as an "intermediate" layer and described in more detail below) underlying the at least one magnetically hard recording layer **6** is comprised of one or more layers of non-magnetic or substantially non-magnetic materials, and serves to (1) prevent magnetic interaction between the soft underlayer **4** and the at least one hard recording layer **6** and (2) promote desired microstructural and magnetic properties of the at least one magnetically hard recording layer **6**.

As shown by the arrows in FIG. 1 indicating the path of the magnetic flux φ, flux φ is seen as emanating from single pole **7** of single-pole magnetic transducer head **16**, entering and passing through the at least one vertically oriented, hard magnetic recording layer **5** in the region below single pole **7**, entering and traveling within soft magnetic underlayer **3** for a distance, and then exiting therefrom and passing through the at least one perpendicular hard magnetic recording layer **6** in the region below auxiliary pole **8** of single-pole magnetic transducer head **16**. The direction of movement of perpendicular magnetic medium **21** past transducer head **16** is indicated in the figure by the arrow above medium **21**.

With continued reference to FIG. 1, vertical lines **9** indicate grain boundaries of polycrystalline layers **5** and **6** of the layer stack constituting medium **21**. Magnetically hard main recording layer **6** is formed on interlayer **5**, and while the grains of each polycrystalline layer may be of differing widths (as measured in a horizontal direction) represented by a grain size distribution, they are generally in vertical registry (i.e., vertically "correlated" or alignad).

Completing the layer stack is a protective overcoat layer **14**, such as of a diamond-like carbon (DLC), formed over hard magnetic layer **6**, and a lubricant topcoat layer **15**, such as of a perfluoropolyethylene material, formed over the protective overcoat layer.

Substrate **10** is typically disk-shaped and comprised of a non-magnetic metal or alloy, e.g., Al or an Al-based alloy, such as Al-Mg having an Ni-P plating layer on the deposition surface thereof, or substrate **10** is comprised of a suitable glass, ceramic, glass-ceramic, polymeric material, or a composite or laminate of these materials. Optional adhesion layer **11A**, if present, may comprise an up to about 40 Å thick layer of a material such as Ti or a Ti alloy. Soft magnetic underlayer **4** is typically comprised of an about 500 to about 4,000 Å thick layer of a soft magnetic material selected from the group consisting of Ni, NiFe (Permalloy), Co, CoZr, CoZrCr, CoZrNb, CoFeZrNb, CoFe, Fe, FeN, FeSiAl, FeSiAIN, FeCoB, FeCoC, etc. Interlayer **5** typically comprises an up to about 300 Å thick layer or layers of non-magnetic material(s), such as Ru, TiCr, Ru/CoCr₃₇Pt₆, RuCr/CoCrPt, etc.; and the at least one hard magnetic layer **6** is typically comprised of an about 100 to about 250 Å thick layer(s) of Co-based alloy(s) including one or more elements selected from the group consisting of Cr, Fe, Ta, Ni, Mo, Pt, V, Nb, Ge, B, and Pd, iron nitrides or oxides. The hard magnetic recording layer **6** material has perpendicular magnetic anisotropy.

A currently employed way of classifying magnetic recording media is on the basis by which the magnetic grains of the recording layer are mutually separated, i.e., segregated, in order to physically and magnetically de-couple the grains and provide improved media performance characteristics. According to this classification scheme, magnetic media with Co-based alloy magnetic recording layers (e.g., CoCr alloys) are classified into two distinct types: (1) a first type, wherein segregation of the grains occurs by diffusion of Cr atoms of the magnetic layer to the grain boundaries of the layer to form Cr-rich grain boundaries, which diffusion process requires heating of the media substrate during formation (deposition) of the magnetic layer; and (2) a second type, wherein segregation of the grains occurs by formation of at least one non-magnetic material selected from among oxides, nitrides, and carbides at the boundaries between adjacent magnetic grains to form so-called "granular" media, which oxides, nitrides, and/or carbides may be formed by introducing a minor amount of at least one reactive gas containing oxygen, nitrogen, and/or carbon atoms (e.g. O₂, N₂, CO₂, etc.) to the inert gas (e.g., Ar) atmosphere during sputter deposition of the Co alloy-based magnetic layer.

Magnetic recording media with granular magnetic recording layers possess great potential for achieving ultra-high areal recording densities. More specifically, magnetic recording media based upon granular recording layers offer the possibility of satisfying the ever-increasing demands on thin film magnetic recording media in terms of coercivity (H_{c}), remanent coercivity (Hcᵣ), magnetic remanence (Mᵣ), coercivity squareness (S*), signal-to-medium noise ratio (SMNR), and thermal stability, as determined by K_{µ}V, where K_{µ} is the magnetic anisotropy constant of the magnetic material and V is the volume of the magnetic grain(s).

As indicated above, current methodology for manufacturing granular-type magnetic recording media involves reactive sputtering of the magnetic recording layer in a reactive gas-containing sputtering atmosphere, e.g., an O₂/Ar and/or N₂/Ar atmosphere, in order to incorporate at least one of oxides, nitrides, and carbides therein and achieve smaller and more isolated magnetic grains. In this regard, it is believed that the introduction of O₂ , N₂ and/or CO₂ into the Ar sputtering atmosphere provides a source af O₂ and/or N₂ that migrates to the intergranular boundaries and forms non-magnetic oxides, nitrides, and/or carbides within the boundaries, thereby providing a structure with reduced exchange coupling between adjacent magnetic grains.

More specifically, the oxygen present at the grain boundaries in the magnetically hard recording layer(s) of granular magnetic media forms amorphous, hard, and brittle boundary regions which confine the growth of the magnetic grains and contribute to grain size refinement. As indicated above, the at least one granular magnetic recording layer 6 is generally formed (e.g., as by sputter deposition) on a non-magnetic (or at most weakly magnetic), crystalline interlayer 5, typically a *hcp* structured layer which enhances the Co <0002> crystalline texture of the overlying Co-based granular magnetic recording layer 6 perpendicular to the to the film plane, thereby resulting in very high perpendicular anisotropy. As a consequence, interlayer 6 plays a critical role in the formation of granular perpendicular magnetic recording media exhibiting optimum recording and stability performance.

Notwithstanding the notable improvements in magnetic recording media performance afforded by the granular media, the continuing requirements for increased recording density and high performance magnetic media, particularly in hard disk form, necessitates further improvement in granular media technology.

In view of the foregoing, there exists a clear need for methodology for manufacturing high areal recording density, high performance granular-type longitudinal and perpendicular magnetic recording media with improved stability and optimal magnetic properties, which methodology is fully compatible with the requirements of high product throughput, cost-effective, automated manufacture of such high performance magnetic recording media.

### SUMMARY OF THE DISCLOSURE

An advantage of the present disclosure is improved Re-based alloy materials.

A further advantage of the present disclosure is improved Re-based alloy materials suitable for use in forming interlayers in granular perpendicular magnetic recording media.

Another advantage of the present disclosure is improved physical vapor deposition (PVD) targets, such as sputtering targets, suitable for use in forming the Re-based interlayers and comprising Re-based alloy materials.

Yet another advantage of the present disclosure is improved granular perpendicular magnetic recording media comprising Re-based alloy interlayers beneath granular perpendicular magnetic recording layers.

A still further advantage of the present disclosure is improved methodology for forming granular perpendicular magnetic recording media comprising Re-based alloy interlayers beneath granular perpendicular magnetic recording layers.

Additional advantages and other features of the present disclosure will be set forth in the description which follows and in part will become apparent to those having ordinary skill in the art upon examination of the following or may be learned from the practice of the present invention. The advantages of the present invention may be realized and obtained as particularly pointed out in the appended claims.

According to an aspect of the present invention, the foregoing and other advantages are obtained in part by improved Re-based alloy materials, comprising > 50 at. % Re and at least one alloying material selected from the group consisting of:
(a) grain size refinement elements X which have an atomic radius larger or smaller than that of Re and a solid solubility < ~ 6 at. % in *hcp* Re at room or higher temperatures; and
(b) lattice matching elements Y which have an atomic radius larger or smaller than that of Re and form a solid solution in *hcp* Re at room or higher temperatures.

In accordance with certain embodiments of the present disclosure, the alloy is of Re-X composition, the at least one element X being selected from the group consisting of: Be, B, Si, Ti, V, Mn, Fe, Cu, Ge, Se, Y, Zr, Nb, Pd, Ag, Sn, Sb, Te, La, Nd, Sm, Gd, Tb, Ho, Er, Yb, Lu, Hf, Ta, Bi, Th, and U, and the alloy material optionally further comprises at least one material selected from the group consisting of oxides, nitrides, and carbides.

According to other embodiments of the present disclosure, the alloy is of Re-Y composition, the at least one element Y being selected from the group consisting of: Al, Mo, W, Os, Pt, Au, C, Cr, Co, Ni, Ir, Ru, Rh, and Os. The alloy material optionally further comprises at least one material selected from the group consisting of oxides, nitrides, and carbides.

Further embodiments according to the present disclosure include those wherein the alloy is of Re-X-Y composition, the at least one element X being selected from the group consisting of: Be, B, Si, Ti, V, Mn, Fe, Cu, Ge,Se, Y, Zr, Nb, Pd, Ag, Sn, Sb, Te, La, Nd, Sm, Gd, Tb, Ho, Er, Yb, Lu, Hf, Ta, Bi, Th, and U and at least one element Y selected from the group consisting of: Al, Mo, W, Os, Pt, Au, C, Cr, Co, Ni, Ir, Ru, Rh, and Os. The alloy material optionally further comprises at least one material selected from the group consisting of oxides, nitrides, and carbides.

Another aspect of the present disclosure is improved physical vapor deposition (PVD) targets, e.g., sputtering targets, comprising the abovementioned Re-based alloy materials.

A further aspect of the present disclosure is improved granular perpendicular magnetic recording media, comprising:
(a) a non-magnetic substrate having a surface; and
(b) a layer stack on the substrate surface, the layer stack including, in order from the surface:
   (i) a non-magnetic or substantially non-magnetic interlayer; and
   (ii) a granular perpendicular magnetic recording layer in overlying contact with the interlayer, wherein:
      the interlayer comprises a Re-based alloy material, comprising > 50 at. % Re and at least one alloying material selected from the group consisting of: grain size refinement elements X which have an atomic radius larger or smaller than that of Re and a solid solubility < ~ 6 at. % in *hcp* Re at room or higher temperatures, and lattice matching elements Y which have an atomic radius different from that of Re and form a solid solution in *hcp* Re at room or higher temperatures.

According to certain embodiments of the present disclosure, the Re-based alloy material of the interlayer is of Re-X composition and comprises at least one element X selected from the group consisting of: Be, B, Si, Ti, V, Mn, Fe, Cu, Ge, Se, Y, Zr, Nb, Pd, Ag, Sn, Sb, Te, La, Nd, Sm, Gd, Tb, Ho, Er, Yb, Lu, Hf, Ta, Bi, Th, and U, and the Re-based alloy material of the interlayer may further comprises at least one material selected from the group consisting of oxides, nitrides, and carbides.

In accordance with other embodiments of the present disclosure, the Re-based alloy material of the interlayer is of Re-Y composition and comprises at least one element Y selected from the group consisting of: Al, Mo, W, Os, Pt, Au, C, Cr, Co, Ni, Ir, Ru, Rh, and Os. The Re-based alloy material of the interlayer may further comprise at least one material selected from the group consisting of oxides, nitrides, and carbides.

Further embodiments of the present disclosure include those wherein the Re-based alloy material of the interlayer is of Re-X-Y composition and comprises at least one element X selected from the group consisting of: Be, B, Si, Ti, V, Mn, Fe, Cu, Ge, Se, Y, Zr, Nb, Pd, Ag, Sn, Sb, Te, La, Nd, Sm, Gd, Tb, Ho, Er, Yb, Lu, Hf, Ta, Bi, Th, and U and at least one element Y selected from the group consisting of: Al, Mo, W, Os, Pt, Au, C, Cr, Co, Ni, Ir, Ru, Rh, and Os. The Re-based alloy material of the interlayer may further comprise at least one material selected from the group consisting of oxides, nitrides, and carbides.

Still another aspect of the present disclosure is an improved method of fabricating a granular perpendicular magnetic recording medium, comprising steps of:
(a) providing a non-magnetic substrate having a surface; and
(b) forming a layer stack on the substrate surface, the layer stack including, in order from the surface:
   (i) a non-magnetic or substantially non-magnetic interlayer; and
   (ii) a granular perpendicular magnetic recording layer in overlying contact with the interlayer, wherein:
      the interlayer comprises a Re-based alloy material, comprising > 50 at. % Re and at least one alloying material selected from the group consisting of: grain size refinement elements X which have an atomic radius larger or smaller than that of Re and a solid solubility < ~ 6 at. % in *hcp* Re at room or higher temperatures, and lattice matching elements Y which have an atomic radius different from that of Re and form a solid solution in *hcp* Re at room or higher temperatures.

According to certain embodiments of the present disclosure, step (b) comprises forming an interlayer of Re-X composition comprising at least one element X selected from the group consisting of: Be, B, Si, Ti, V, Mn, Fe, Cu, Ge, Se, Y, Zr, Nb, Pd, Ag, Sn, Sb, Te, La, Nd, Sm, Gd, Tb, Ho, Er, Yb, Lu, Hf, Ta, Bi, Th, and U, The interlayer may further comprise at least one material selected from the group consisting of oxides, nitrides, and carbides,

In accordance with other embodiments of the present disclosure, step (b) comprises forming an interlayer of Re-Y composition comprising at least one element Y selected from the group consisting of: Al, Mo, W, Os, Pt, Au, C, Cr, Co, Ni, Ir, Ru, Rh, and Os. The interlayer may further comprise at least one material selected from the group consisting of oxides, nitrides, and carbides.

Further embodiments of the present disclosure include those wherein step (b) comprises forming an interlayer of Re-X-Y composition comprising at least one element X selected from the group consisting of Be, B, Si, Ti, V, Mn, Fe, Cu, Ge, Se, Y, Zr, Nb, Pd, Ag, Sn, Sb, Te, La, Nd, Sm, Gd, Tb, Ho, Er, Yb, Lu, Hf, Ta, Bi, Th, and U and at least one element Y selected from the group consisting of: Al, Mo, W, Os, Pt, Au, C, Cr, Co, Ni, Ir, Ru, Rh, and Os. The interlayer may further comprise at least one material selected from the group consisting of oxides, nitrides, and carbides,

Preferably, step (b) comprises forming the interlayer by a sputter deposition process utilizing one or more targets, as by performing one of the following alternative sputter deposition processes:
(a) sputter deposition utilizing a target comprised of a Re-X alloy, where Re > 50 at. % and X is at least one element selected from the group consisting of: Be, B, Si, Ti, V, Mn, Fe, Cu, Ge, Se, Y, Zr, Nb, Pd, Ag, Sn, Sb, Te, La, Nd, Sm, Gd, Tb, Ho, Er, Yb, Lu, Hf, Ta, Bi, Th, and U;
(b) sputter deposition utilizing a target as in alternative (a), the target further comprising at least one material selected from the group consisting of oxides, nitrides, and carbides;
(c) sputter deposition utilizing a target comprised of a Re-Y alloy, where Re > 50 at. % and Y is at least one element selected from the group consisting of: Al, Mo, W, Os, Pt, Au, C, Cr, Co, Ni, Ir, Ru, Rh, and Os;
(d) sputter deposition utilizing a target as in alternative (c), the target further comprising at least one material selected from the group consisting of oxides, nitrides, and carbides;
(e) sputter deposition utilizing a target comprised of a Re-X-Y alloy, where Re> 50 at. %, X is at least one element selected from the group consisting of: Be, B, Si, Ti, V, Mn, Fe, Cu, Ge, Se, Y, Zr, Nb, Pd, Ag, Sn, Sb, Te, La, Nd, Sm, Gd, Tb, Ho, Er, Yb, Lu, Hf, Ta, Bi, Th, and U, and Y is at least one element selected from the group consisting of: Al, Mo, W, Os, Pt, Au, C, Cr, Co, Ni, Ir, Ru, Rh, and Os;
(f) sputter deposition utilizing a target as in alternative (e), the target further comprising at least one material selected from the group consisting of oxides, nitrides, and carbides;
(g) sputter deposition utilizing a first target as in alternative`(a) and a second target as in alternative (c); or
(h) sputter deposition utilizing a first target as in alternative (a) and a second target as in alternative (c), at least one of the first and second targets further comprising at least one material selected from the group consisting of oxides, nitrides, and carbides.

Additional advantages and aspects of the disclosure will become readily apparent to those skilled in the art from the following detailed description, wherein embodiments of the present methodology are shown and described, simply by way of illustration of the best mode contemplated for practicing the present invention. As will be described, the present disclosure is capable of other and different embodiments, and its several details are susceptible of modification in various obvious respects, all without departing from the spirit of the present invention. Accordingly, the drawing and description are to be regarded as illustrative in nature, and not as limitative.

### BRIEF DESCRIPTION OF THE DRAWING

The following detailed description of the embodiments of the present disclosure can best be understood when read in conjunction with the following drawing, in which the various features (e.g., layers) are not necessarily drawn to scale but rather are drawn as to best illustrate the pertinent features, wherein:
FIG. 1 schematically illustrates, in simplified cross-sectional view, a portion of a magnetic recording storage, and retrieval system comprised of a perpendicular magnetic recording medium and a single pole transducer head.

### DETAILED DESCRIPTION OF THE DISCLOSURE

The present disclosure has as an aim provision of improved Re-based alloys for use, *inter alia,* as interlayers in the manufacture of stable, high performance, ultra-high areal recording density granular perpendicular magnetic recording media with low media noise. A key requirement for obtaining such high performance media is formation of magnetically hard granular perpendicular recording layers with well-isolated, fine grain structure coupled with large perpendicular magnetic anisotropy Kᵤ.

As indicated *supra,* in such granular perpendicular magnetic recording media, the principal magnetic recording layer typically is an oxygen-containing CoCrPt alloy layer, wherein the oxygen present at the grain boundaries forms amorphous, hard, and brittle grain boundary regions. The oxygen present at the grain boundaries confines the grain growth and thus contributes to grain size refinement. The granular perpendicular magnetic recording layer is usually deposited on a non-magnetic or weakly magnetic, crystalline *hcp*-based interlayer which enhances the Co <0002> texture of the Co-based magnetically hard recording layer perpendicular to the film plane, thus leading to high perpendicular magnetic anisotropy Kᵤ.

The present disclosure is based upon recognition that rhenium (Re) layers, in view of the *hcp* crystal structure of Re at room temperature and its relative inertness (e.g., reduction potential is 0.276 V), are generally resistant to oxide formation at its interface with oxygen-containing granular perpendicular magnetic alloy layers. As a consequence, it has been recognized that Re and Re-based alloys are excellent candidates for use as interlayers in the formation of granular perpendicular magnetic recording media.

In this regard, it is important to note that the interlayer of granular perpendicular magnetic recording media functions not only to enhance the crystallographic texturing of the overlying granular magnetic recording layer, but can also contribute to its grain size refinement when the latter is epitaxially grown on an interlayer with refined grain sizes. Further, close lattice matching between the interlayer and the overlying granular recording layer ensures formation of a substantially defect-free interface therebetween, reducing likelihood of in-plane magnetization.

Briefly stated, according to a key feature of the present disclosure, grain size refinement of the interlayer, as well as of the overlying granular recording layer, is obtained by use of interlayers comprising Re-based alloy materials, i.e., where Re > ~ 50 at. %, containing one or more first type alloying additives, e.g., one or more elements X, optionally with or one or more oxides, nitrides, and/or carbides. Alloying elements X for this purpose function as grain size refiners when they are: (1) substantially insoluble in Re at room temperature or have limited solubility (i.e., < ~ 6 at. %) in Re at higher temperatures, and (2) form amorphous, hard, brittle grain boundary regions and confine grain growth in the interlayer.

Another key feature of the present disclosure arises from the requirement for strong <0002> orientation of the Co-based *hcp* granular perpendicular magnetic recording layer, which requirement is met by orienting the *hcp* <0002> crystal planes parallel to the film plane. However, any lattice mismatch at the interface between the interlayer and the granular recording layer can result in defects which enhance undesirable in-plane magnetization. According to the present disclosure, lattice mismatch (or misfit) between the crystalline Re-based interlayer and the overlying Co-based granular perpendicular magnetic recording layer is mitigated, i.e., reduced, by inclusion of one or more second type alloying additives, e.g., one or more elements Y, with or without one or more oxides and/or nitrides. Alloying elements Y for the purpose of lattice matching are: (1) soluble in *hcp* Re at room temperature and elevated temperatures, and form solid solutions therewith, and (2) have a larger or smaller atomic radius than Re. The alloying elements Y modify the in-plane ("a" axis) lattice parameter of Re and thereby function to reduce any lattice mismatch or misfit between the crystalline Re-based interlayer and the overlying Co-based granular perpendicular magnetic recording layer. For example, addition of alloying elements Y with smaller atomic radius than Re (i.e., < 1.37 Å) serve to contract the Re alloy lattice, whereas addition of alloying elements Y with larger atomic radius than Re (i.e., > 1.37 Å) serve to expand the Re alloy lattice.

According to another key feature of the present disclosure and illustrating its versatility, is the ability to utilize Re-based alloys containing either one of X or Y alloying additives (as in Re-X and Re-Y alloys) or both X and Y alloying additives (as in Re-X-Y alloys).

Elements suitable for use as alloying additives X for Re-X alloys are presented in Table I below. As indicated above, a crystalline interlayer, such as interlayer 5 shown in FIG. 1, having refined grain sizes can function to control/refine the grain sizes of the granular perpendicular magnetic recording layer when the latter layer is grown epitaxially on the surface of the former layer. This effect is enhanced when the interlayer comprises an alloy of Re and a grain size refining additive such as element X. In order to function as a grain size refiner, the alloying additive element X must have no solubility in Re at room temperature, or very low solubility, i.e., < ~ 6 at. % in Re at higher temperatures. The lack of solubility permits the alloying additive to form amorphous, hard, brittle grain boundaries in the Re-based interlayer, thereby confining grain growth during sputter deposition of the interlayer and the subsequently deposited granular perpendicular magnetic recording layer. The alloying additive element may, but is not required to, be non-magnetic or weakly magnetic, e.g., with a mass susceptibility of < 1.5 x 10⁻⁷ m³/kg, and may have an atomic radius greater or smaller than that of Re. The alloying additive element(s) can be present in excess of the maximum solubility limit of the element(s) in pure Re at room temperature or above. Finally, the grain size refining element(s) may be utilized in combination with at least one material selected from the group consisting of oxides, nitrides, and carbides of any of the elements of Table I, or any other metal, as they function in similar manner as grain size refiners by forming amorphous grain boundaries.

Based on the above criteria, Re-X alloys according to the present disclosure may include one or more of Be, B, Si, Ti, V, Mn, Fe, Cu, Ge, Se, Y, Zr, Nb, Pd, Ag, Sn, Sb, Te, La, Nd, Sm, Gd, Tb, Ho, Er, Yb, Lu, Hf, Ta, Bi, Th, and U.

**Table I**

| | **At No.** | **At.Radius** | **X-tal structure** | **Mass susceptibilty (10-8 m3/kg)** | **RT solubility in Re** |
|---|---|---|---|---|---|
| Be | 4 | 1.13 | hexagonal | -1.26 | Insoluble |
| B | 5 | 0.97 | rhomb | -0.87 | 1%(2150C), insoluble (RT) |
| Si | 14 | 1.32 | diamond | -0.16 | 10% (1710C), 1% (1300C) |
| Ti | 22 | 1.47 | hexagonal | 4.21 | 2.5%(2750C), insoluble (RT) |
| V | 23 | 1.36 | bcc | 6.28 | 12% (2460C),2% (₈0CC) |
| Mn | 25 | 1.35 | cub | 12.2 | insoluble |
| Fe | 26 | 1.26 | bcc | | Insoluble |
| Cu | 29 | 1.28 | fcc | -0.1 | insoluble |
| Ge | 32 | 1.37 | cubic | | Insoluble |
| Se | 34 | 1.16 | monoclinic | | insoluble |
| Y | 39 | 1.81 | hexagonal | 6.66 | Insoluble |
| Zr | 40 | 1.6 | hexagonal | 1.66 | 1% (2500C) |
| Nb | 41 | 1.47 | bcc | 2.81 | 4%(2715C), 1% (800C) |
| Pd | 46 | 1.37 | fcc | 6.57 | 5% (1650C), 2% (1000c) |
| Ag | 47 | 1.44 | fcc | -0.23 | insoluble |
| Sn | 50 | 1.58 | diamond | -0.31 | insoluble |
| Sb | 51 | 1.61 | trigonal | -1.09 | insoluble |
| Te | 52 | 1.43 | hexagonal | -0.39 | insoluble |
| La | 57 | 1.38 | hexagonal | | insoluble |
| Nd | 60 | 1.82 | hexagonal | | insoluble |
| Sm | 62 | 1.8 | trigonal | | insoluble |
| Gd | 64 | 1.81 | hexagonal | | insoluble |
| Tb | 65 | 1.76 | hexagonal | | 1% (2450C), insoluble (RT) |
| Ho | 67 | 1.78 | hexagonal | | insoluble |
| Er | 68 | 1.79 | hexagonal | | insoluble |
| Yb | 70 | 1.93 | fcc | 0.59 | insoluble |
| Lu | 71 | 1.73 | hexagonal | 0.12 | Insoluble |
| Hf | 72 | 1.59 | hexagonal | 0.53 | insoluble |
| Ta | 73 | 1.47 | bee | 1.07 | 5.1%(2755C), 4% (2000C) |
| Bi | 83 | 1.75 | monoclinic | -1.7 | insoluble |
| Th | 90 | 1.8 | fcc | 0.53 | insoluble |
| U | 92 | 1.39 | orthorhombic | | insoluble |

Elements suitable for use as alloying additives Y for Re-Y alloys according to the present disclosure are presented in Tables II and III below. As indicated above, the *hcp* Co-based granular perpendicular magnetic recording layer is deposited on the upper surface of the *hcp* Re-based interlayer. Since Pt is highly soluble in Co at room temperature, incorporation of Pt in Co can result in significant change in the "a" axis lattice parameter of Co because of the larger atomic radius of Pt. According to the present disclosure, the alloying additive elements Y, when present in the Re interlayer, change the "a" axis lattice parameter of Re by formation of solid solutions with Re at room temperature or above. The alloying additive element may, but is not required to, be non-magnetic or weakly magnetic, e.g., with a mass susceptibility of < 1.5 x 10⁻⁷ m³/kg.

Alloying additive elements Y for Re-Y alloys which have atomic radius larger than Re, and thus expand the lattice of Re-based interlayers are given in Table II below, whereas alloying additive elements Y for Re-Y alloys which have atomic radius smaller than Re, and thus contract the lattice of Re-based interlayers are given in Table III below.

**Table II**

| | **At No.** | **At.Radtus** | **X-tal structure** | **Mass susceptibilty (10-8 m3/kg)** | **RT solubility in Re** |
|---|---|---|---|---|---|
| Al | 13 | 1.43 | fcc | 0.82 | ~2.8at%(RT) |
| Mo | 42 | 1.4 | bcc | 1.17 | 15%(2645C),8%(500C) |
| W | 74 | 1.41 | bcc | 0.39 | 20%(2825C),12%(1500C) |
| Os | 76 | 1.38 | hexagonal | 0.06 | soluble |
| Pt | 78 | 1.38 | fcc | 1.22 | 45%(2450C), 40% (600C) |
| Au | 79 | 1.44 | fcc | -0.18 | NA,however thin film of Au-Re shows Au having solubility of 42% at 500C |

**Table III**

| | **At No.** | **At.Radius** | **X-tal structure** | **Mass susceptibilty (10-8 m3/kg)** | **RT solubility in Re** |
|---|---|---|---|---|---|
| C | 6 | 0.77 | diamond | -0.62 | 11%(2505C), 7%(2200C) |
| Cr | 24 | 1.28 | bcc | 4.45 | 25% (2354C), 10% (1500C) |
| Co | 27 | 1.25 | hexagonal | | soluble |
| Ni | 28 | 1.24 | cubic | | 17.7%(1620C),9% (600C) |
| Ir | 77 | 1.35 | fcc | 0.23 | 15%(2645C),8%(500C) |
| Ru | 44 | 1.34 | hexagonal | 0.54 | soluble |
| Rh | 45 | 1.34 | fcc | 1.32 | 24% (2620C). 12% (500C) |
| Os | 76 | 1.38 | hexagonal | 0.06 | soluble |

The alloying additive element(s) Y can perform lattice parameter modulation and reduce mismatch/misfit of the Re-based interlayer with the overlying granular perpendicular magnetic recording layer when added to pure Re in amounts within or up to their maximum solubility limit. Alloying additive elements Y can also serve a dual purpose of providing grain size refinement and lattice matching when added in excess of the maximum solubility limit. Finally, alloying additive elements can be added to the Re in combination with one or more material selected from among oxides, nitrides, and carbides, in which instance the latter function as grain size refiners.

As indicated above, the present disclosure contemplates formation of Re-based alloys and PVD sources, e.g., sputtering targets, containing at least one X or Y alloying additive (as in Re-X and Re-Y alloys) or both X and Y alloying additives (as in Re-X-Y alloys), which alloys and targets comprising same are advantageously utilized for forming improved interlayers for granular perpendicular magnetic recording media. Each of the Re-based alloys and PVD sources (e.g., sputtering targets) contemplated by the present disclosure can be fabricated by conventional methodologies, including, for example, powder metallurgical techniques comprising consolidation and densification of powders of the constituents or by solidification metallurgical techniques comprising melting and casting of the alloy compositions.

According to the present disclosure, the interlayers are preferably formed by sputter deposition techniques, including reactive and/or non-reactive sputtering utilizing a single target or co-sputtering of plural targets, as for example, by performing one of the following alternative sputter deposition processes:
(a) sputter deposition utilizing a target comprised of a Re-X alloy, where Re > 50 at. % and X is at least one element selected from the group consisting of: Be, B, Si, Ti, V, Mn, Fe, Cu, Ge, Se, Y, Zr, Nb, Pd, Ag, Sn, Sb, Te, La, Nd, Sm, Gd, Tb, Ho, Er, Yb, Lu, Hf, Ta, Bi, Th, and U;
(b) sputter deposition utilizing a target as in alternative (a), the target further comprising at least one material selected from the group consisting of oxides, nitrides, and carbides;
(c) sputter deposition utilizing a target comprised of a Re-Y alloy, where Re > 50 at. % and Y is at least one element selected from the group consisting of: Al, Mo, W, Os, Pt, Au, C, Cr, Co, Ni, Ir, Ru, Rh, and Os;
(d) sputter deposition utilizing a target as in alternative (c), the target further comprising at least one material selected from the group consisting of oxides, nitrides, and carbides;
(e) sputter deposition utilizing a target comprised of a Re-X-Y alloy, where Re > 50 at. %, X is at least one element selected from the group consisting of: Be, B, Si, Ti, V, Mn, Fe, Cu, Ge, Se, Y, Zr, Nb, Pd, Ag, Sn, Sb, Te, La, Nd, Sm, Gd, Tb, Ho, Er, Yb, Lu, Hf, Ta, Bi, Th, and U, and Y is at least one element selected from the group consisting of: Al, Mo, W, Os, Pt, Au, C, Cr, Co, Ni, Ir, Ru, Rh, and Os;
(f) sputter deposition utilizing a target as in alternative (e), the target further comprising at least one material selected from the group consisting of oxides, nitrides, and carbides;
(g) sputter deposition utilizing a first target as in alternative (a) and a second target as in alternative (c); or
(h) sputter deposition utilizing a first target as in alternative (a) and a second target as in alternative (c), at least one of the first and second targets further comprising at least one material selected from the group consisting of oxides, nitrides, and carbides.

In summary, the present disclosure provides improved Re-based alloys containing alloying additives which are particularly useful in the formation of crystalline interlayers in layer stacks of thin film, Co-based granular perpendicular magnetic recording media. Certain of the alloying additives promote refined grain size in the as-formed interlayers as well as in the subsequently deposited granular perpendicular magnetic recording layers, whereas other alloying additives reduce lattice mismatch/misfit between the Re-based interlayer and the overlying Co-based granular perpendicular magnetic recording layer. The enhanced magnetic recording layers afforded by the present disclosure facilitate manufacture of high performance, high areal recording density granular perpendicular magnetic recording media with improved signal-to-noise ratio (SNR) and increased perpendicular magnetic anisotropy.

In the previous description, numerous specific details are set forth, such as specific materials, structures, processes, etc., in order to provide a better understanding of the present invention. However, the present invention, can be practiced without resorting to the details specifically set forth herein. In other instances, well-known processing techniques and structures have not been described in order not to unnecessarily obscure the present invention.

Only the preferred embodiments of the present invention and but a few examples of its versatility are shown and described in the present disclosure. It is to be understood that the present invention is capable of use in various other combinations and environments and is susceptible of changes and/or modifications within the scope of the inventive concept as expressed herein.

## Claims

1. A Re-based alloy material, comprising > 50 at. % Re and at least one alloying material selected from the group consisting of:
(a) grain size refinement elements X which have an atomic radius larger or smaller than that of Re and a solid solubility < ~6 at. % in *hcp* Re at room or higher temperatures; and
(b) lattice matching elements Y which have an atomic radius larger or smaller than that of Re and form a solid solution in *hcp* Re at room or higher temperatures.

2. The alloy material as in claim 1, having a composition Re-X and comprising at least one element X selected from the group consisting of: Be, B, Si, Ti, V, Mn, Fe, Cu, Ge, Se, Y, Zr, Nb, Pd, Ag, Sn, Sb, Te, La, Nd, Sm, Gd, Tb, Ho, Er, Yb, Lu, Hf, Ta, Bi, Th, and U.

3. The alloy material as in claim 2, further comprising at least one material selected from the group consisting of oxides, nitrides, and carbides.

4. The alloy material as in claim 1, having a composition Re-Y and comprising at least one element Y selected from the group consisting of: Al, Mo, W, Os, Pt, Au, C, Cr, Co, Ni, Ir, Ru, Rh, and Os.

5. The alloy material as in claim 4, further comprising at least one material selected from the group consisting of oxides, nitrides, and carbides.

6. The alloy material as in claim 1, having a composition Re-X-Y and comprising at least one element X selected from the group consisting of: Be, B, Si, Ti, V, Mn, Fe, Cu, Ge, Se, Y, Zr, Nb, Pd, Ag, Sn, Sb, Te, La, Nd, Sm, Gd, Tb, Ho, Er, Yb, Lu, Hf, Ta, Bi, Th, and U and at least one element Y selected from the group consisting of: Al, Mo, W, Os, Pt, Au, C, Cr, Co, Ni, Ir, Ru, Rh, and Os.

7. The alloy material as in claim 6, further comprising at least one material selected from the group consisting of oxides, nitrides, and carbides.

8. A physical vapor deposition (PVD) target comprising the Re-based alloy material of claim 2.

9. A physical vapor deposition (PVD) target comprising the Re-based alloy material of claim 5.

10. A granular perpendicular magnetic recording medium, comprising:
(a) a non-magnetic substrate having a surface; and
(b) a layer stack on said substrate surface, said layer stack including, in order from said surface:
(i) a non-magnetic or substantially non-magnetic interlayer; and
(ii) a granular perpendicular magnetic recording layer in overlying contact with said interlayer, wherein:
said interlayer comprises a Re-based alloy material, comprising > 50 at. % Re and at least one alloying material selected from the group consisting of: grain size refinement elements X which have an atomic radius larger or smaller than that of Re and a solid solubility < ~6 at. % in *hcp* Re at room or higher temperatures, and lattice matching elements Y which have an atomic radius different from that of Re and form a solid solution in *hcp* Re at room or higher temperatures.

11. The medium as in claim 10, wherein:
said Re-based alloy material of said interlayer is of Re-X composition and comprises at least one element X selected from the group consisting of; Be, B, Si, Ti, V, Mn, Fe, Cu, Ge, Se, Y, Zr, Nb, Pd, Ag, Sn, Sb, Te, La, Nd, Sm, Gd, Tb, Ho, Er, Yb, Lu, Hf, Ta, Bi, Th, and U.

12. The medium as in claim 11, wherein:
said Re-based alloy material of said interlayer further comprises at least one material selected from the group consisting of oxides, nitrides, and carbides.

13. The medium as in claim 10, wherein:
said Re-based alloy material of said interlayer is of Re-Y composition and comprises at least one clement Y selected from the group consisting of: Al, Mo, W, Os, Pt, Au, C, Cr, Co, Ni, Ir, Ru, Rh, and Os.

14. The medium as in claim 13, wherein:
said Re-based alloy material of said interlayer further comprises at least one material selected from the group consisting of oxides, nitrides, and carbides.

15. The medium as in claim 10, wherein:
said Re-based alloy material of said interlayer is of Re-X-Y composition and comprises at least one element X selected from the group consisting of: Be, B, Si, Ti, V, Mn, Fe, Cu, Ge, Se, Y, Zr, Nb, Pd, Ag, Sn, Sb, Te, La, Nd, Sm, Gd, Tb, Ho, Er, Yb, Lu, Hf, Ta, Bi, Th, and U and at least one element Y selected from the group consisting of: Al, Mo, W, Os, Pt, Au, C, Cr, Co, Ni, Ir, Ru, Rh, and Os.

16. The medium as in claim 15, wherein:
said Re-based alloy material of said interlayer further comprises at least one material selected from the group consisting of oxides, nitrides, and carbides.

17. A method of fabricating a granular perpendicular magnetic recording medium, comprising steps of:
(a) providing a non-magnetic substrate having a surface; and
(b) forming a layer stack on said substrate surface, said layer stack including, in order from said surface:
(i) a non-magnetic or substantially non-magnetic interlayer, and
(ii) a granular perpendicular magnetic recording layer in overlying contact with said interlayer, wherein:
said interlayer comprises a Re-based alloy material, comprising > 50 at. % Re and at least one alloying material selected from the group consisting of: grain size refinement elements X which have an atomic radius larger or smaller than that of Re and a solid solubility < ~6 at. % in *hcp* Re at room or higher temperatures, and lattice matching elements Y which have an atomic radius different from that of Re and form a solid solution in *hcp* Re at room or higher temperatures.

18. The method according to claim 17, wherein step (b) comprises forming a said interlayer with Re-X composition and comprising at least one element X selected from the group consisting of: Be, B, Si, Ti, V, Mn, Fe, Cu, Ge, Se, Y, Zr, Nb, Pd, Ag, Sn, Sb, Te, La, Nd, Sm, Gd, Tb, Ho, Er, Yb, Lu, Hf, Ta, Bi, Th, and U.

19. The method according to claim 18, wherein step (b) comprises forming a said interlayer which further comprises at least one material selected from the group consisting of oxides, nitrides, and carbides.

20. The method according to claim 17, wherein step (b) comprises forming a said interlayer with Re-Y composition and comprising at least one element Y selected from the group consisting of: Al, Mo, W, Os, Pt, Au, C, Cr, Co, Ni, Ir, Ru, Rh, and Os.

21. The method according to claim 20, wherein step (b) comprises forming a said interlayer which further comprises at least one material selected from the group consisting of oxides, nitrides, and carbides.

22. The method according to claim 17, wherein step (b) comprises forming a said interlayer with Re-X-Y composition and comprising at least one element X selected from the group consisting of: Be, B, Si, Ti, V, Mn, Fe, Cu, Ge, Se, Y, Zr, Nb, Pd, Ag, Sn, Sb, Te, La, Nd, Sm, Gd, Tb, Ho, Er, Yb, Lu, Hf, Ta, Bi, Th, and U and at least one element Y selected from the group consisting of Al, Mo, W, Os, Pt, Au, C, Cr, Co, Ni, Ir, Ru, Rh, and Os.

23. The method according to claim 22, wherein step (b) comprises forming a said interlayer which further comprises at least one material selected from the group consisting of oxides, nitrides, and carbides.

24. The method according to claim 17, wherein step (b) comprises forming said interlayer by a sputter deposition process utilizing one or more targets.

25. The method according to claim 25, wherein step (b) comprises performing one of the following alternative sputter deposition processes:
(a) sputter deposition utilizing a target comprised of a Re-X alloy, where Re > 50 at. % and X is at least one element selected from the group consisting of: Be, B, Si, Ti, V, Mn, Fe, Cu, Ge, Se, Y, Zr, Nb, Pd, Ag, Sn, Sb, Te, La, Nd, Sm, Gd, Tb, Ho, Er, Yb, Lu, Hf, Ta, Bi, Th, and U;
(b) sputter deposition utilizing a target as in alternative (a), said target further comprising at least one material selected from the group consisting of oxides, nitrides, and carbides;
(c) sputter deposition utilizing a target comprised of a Re-Y alloy, where Re > 50 at. % and Y is at least one element selected from the group consisting of Al, Mo, W, Os, Pt, Au, C, Cr, Co, Ni, Ir, Ru, Rh, and Os;
(d) sputter deposition utilizing a target as in alternative (c), said target further comprising at least one material selected from the group consisting of oxides, nitrides, and carbides;
(e) sputter deposition utilizing a target comprised of a Re-X-Y alloy, where Re > 50 at. %, X is at least one element selected from the group consisting of: Be, B, Si, Ti, V, Mn, Fe, Cu, Ge, Se, Y, Zr, Nb, Pd, Ag, Sn, Sb, Te, La, Nd, Sm, Gd, Tb, Ho, Er, Yb, Lu, Hf, Ta, Bi, Th, and U, and Y is at least one element selected from the group consisting of: Al, Mo, W, Os, Pt, Au, C, Cr, Co, Ni, Ir, Ru, Rh, and Os;
(f) sputter deposition utilizing a target as in alternative (e), said target further comprising at least one material selected from the group consisting of oxides, nitrides, and carbides;
(g) sputter deposition utilizing a first target as in alternative (a) and a second target as in alternative (c); and
(h) sputter deposition utilizing a first target as in alternative (a) and a second target as in alternative (c), at least one of said first and second targets further comprising at least one material selected from the group consisting of oxides, nitrides, and carbides.
